# EUROPEAN PATENT APPLICATION

(11) **EP 4 651 137 A1**
(43) Date of publication of application: **19.11.2025**
(21) Application number: 23919372.5
(22) Date of filing: 13.10.2023
(51) Int. Cl.: G11C 11/22

(54) **STORAGE ARRAY, STORAGE APPARATUS, AND ELECTRONIC DEVICE**

(30) Priority: 31.01.2023 CN 202310128600
(71) Applicant: Huawei Technologies Co., Ltd., Shenzhen, Guangdong 518129 (CN)
(72) Inventor: LI, Hao, Shenzhen, Guangdong 518129 (CN); YANG, Ruhui, Shenzhen, Guangdong 518129 (CN); ZHANG, Min, Shenzhen, Guangdong 518129 (CN); JIA, Xiufeng, Shenzhen, Guangdong 518129 (CN)
(74) Representative: Isarpatent
(86) International application number: PCT/CN2023/124416
(87) International publication number: WO 2024/159808

(57) **Abstract**

This application provides a memory array, a memory apparatus, and an electronic device, and relates to the field of storage technologies. The memory array includes a plurality of memory cells and a plurality of bit lines that are arranged in an array. Each memory cell includes a first N-channel transistor and a first P-channel transistor that are distributed in a column direction. In each memory cell in a same column, a source or a drain of the first N-channel transistor and a source or a drain of the first P-channel transistor are electrically connected to a same bit line. In at least two partially adjacent memory cells in the same column, two first N-channel transistors are adjacently disposed, or two first P-channel transistors are adjacently disposed. Two adjacent transistors are set to be of a same type, to reduce a quantity of times of changing active regions, and reduce a spacing (that is, reduce transition space) between the two transistors. This further reduces an area of the memory cell and improves storage density.

## Description

This application claims priority to Chinese Patent Application No. 202310128600.5, filed with the China National Intellectual Property Administration on January 31, 2023 and entitled "MEMORY ARRAY, MEMORY APPARATUS, AND ELECTRONIC DEVICE", which is incorporated herein by reference in its entirety.

### TECHNICAL FIELD

This application relates to the field of storage technologies, and in particular, to a memory array, a memory apparatus, and an electronic device.

### BACKGROUND

A 1T1C (one-transistor one-capacitor, one-transistor one-capacitor) structure is usually used for a basic memory cell of a ferroelectric random access memory (ferroelectric random access memory, FeRAM), a transistor of the memory cell is usually an N-channel metal oxide semiconductor transistor (N-channel metal oxide semiconductor field effect transistor, NMOS FET or NMOS), and a capacitor is usually a ferroelectric capacitor. As semiconductor process nodes improve, a size of a transistor (NMOS) becomes smaller, and an operating transmission voltage becomes lower. However, because a ferroelectric thin film of the ferroelectric capacitor requires a high operating voltage, a size of the transistor is limited from further reduction, and improvement of storage density of the FeRAM is limited.

In the conventional technology, a memory cell with a 2T1C (two-transistor one-capacitor, two-transistor one-capacitor) structure is further provided. Two transistors of the memory cell are an NMOS and a PMOS (P-channel metal oxide semiconductor transistor, P-channel metal oxide semiconductor field effect transistor, PMOS FET for short). A high voltage is transmitted by using the PMOS, and a low voltage is transmitted by using the NMOS, to meet the requirement of the ferroelectric thin film for the high operating voltage. In other words, a combination of the NMOS and the PMOS is used in the 2T1C structure, instead of the single NMOS in the 1T1C structure, to prevent a transmission voltage drop due to the reduction in the size of the transistor in the 1T1C structure.

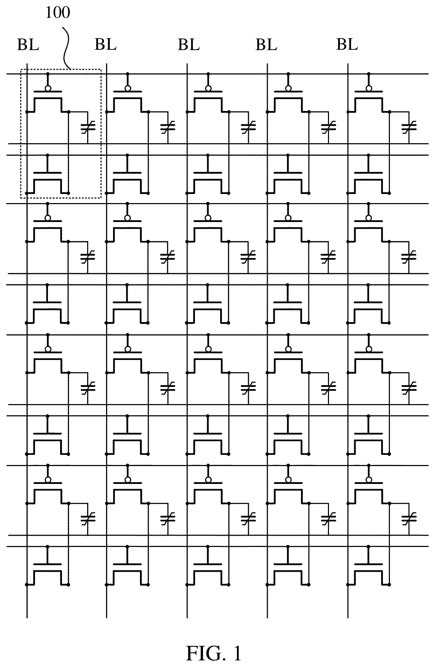

FIG. 1 is a diagram of a memory array with a 2T1C structure in the conventional technology. Refer to FIG. 1. In the memory array, transistors (NMOSs and PMOSs) of a plurality of memory cells 100 in a same column are connected to a same bit line BL (bit line), and are in an extension direction of the bit line BL, the plurality of transistors are alternately arranged as one P-channel transistor (PMOS) and one N-channel transistor (NMOS) in sequence. In other words, the plurality of transistor are alternately arranged based on PNPNPN types. In this case, in the extension direction of the bit line BL, types of transistors in adjacent rows need to be changed, and correspondingly, types of active regions of the transistors in the adjacent rows also need to be changed. To ensure process reliability, when the adjacent active regions in the extension direction of the bit line BL are changed, sufficient transition space needs to be reserved, and the transition space cannot be used. Consequently, an area of the memory cell is increased, and improvement of the storage density is limited.

### SUMMARY

This application provides a memory array, a memory apparatus, and an electronic device, to reduce an area of a memory cell and improve storage density.

This application provides a memory array. The memory array includes a plurality of memory cells and a plurality of bit lines that are arranged in an array, and each memory cell includes a first N-channel transistor and a first P-channel transistor that are distributed in a column direction. In each memory cell in a same column, a source or a drain of the first N-channel transistor and a source or a drain of the first P-channel transistor are electrically connected to a same bit line. In at least two partially adjacent memory cells in the same column, two first N-channel transistors are adjacently disposed or two first P-channel transistors are adjacently disposed. Two adjacent transistors are set to be of a same type, to reduce a quantity of times of changing active regions, and reduce a spacing (that is, reduce transition space) between the two transistors. This further reduces an area of the memory cell and improves storage density.

In some possible implementations, the memory array further includes a plurality of word line groups that are respectively disposed corresponding to a plurality of rows of memory cells. Each word line group includes a first word line and a second word line. In a plurality of memory cells in a same row, a plurality of first N-channel transistors are located in a same row and are electrically connected to first word lines, and a plurality of first P-channel transistors are located in a same row and are electrically connected to second word lines.

In some possible implementations, the memory array further includes a plurality of local bit lines and a plurality of first gating units that are disposed corresponding to each bit line, transistors of a plurality of memory cells in the same column are connected in parts to the plurality of local bit lines, and the plurality of local bit lines are connected to the bit line by using the plurality of first gating units respectively.

In some possible implementations, the first gating unit includes a second N-channel transistor and a second P-channel transistor that are distributed in the column direction, and the local bit line is connected to the bit line by using the second N-channel transistor and the second P-channel transistor that are connected in parallel. Transistors of a plurality of memory cells and transistors of a first gating unit are located in a same column, where the plurality of memory cells and the first gating unit are connected to a same local bit line, second N-channel transistors and second P-channel transistors of the first gating units are distributed on two sides of the plurality of memory cells, the second N-channel transistor is disposed adjacent to the first N-channel transistor, and the second P-channel transistor is disposed adjacent to the first P-channel transistor.

In some possible implementations, the memory cell further includes a first capacitor electrically connected to the first N-channel transistor and the first P-channel transistor. The memory array further includes a first plate line, a plurality of plate line gating units, and a plurality of first local plate lines that are disposed corresponding to a plurality of columns of memory cells, the plurality of first local plate lines are electrically connected to first capacitors in the plurality of memory cells located in different rows respectively, and the first plate line is electrically connected to the plurality of first local plate lines by using the plurality of plate line gating units respectively. The plate line gating unit includes a third N-channel transistor and a third P-channel transistor that are distributed in the column direction. The first plate line is connected to the first local plate line by using the third N-channel transistor and the third P-channel transistor that are connected in parallel, the plurality of plate line gating units are distributed in the column direction, and in at least two partially adjacent plate line gating units, two third N-channel transistors are adjacently disposed or two third P-channel transistors are adjacently disposed.

In some possible implementations, the memory array further includes a plurality of second local plate lines and a plurality of second gating units that are disposed corresponding to the first plate line, transistors of the plurality of plate line gating units are connected in parts to the plurality of second local plate lines, and the plurality of second local plate lines are connected to the first plate line by using the plurality of second gating units respectively.

In some possible implementations, the second gating unit includes a fourth N-channel transistor and a fourth P-channel transistor that are distributed in the column direction. The second local plate line is connected to the first plate line by using the fourth N-channel transistor and the fourth P-channel transistor that are connected in parallel, transistors of a plurality of plate line gating units and transistors of a second gating unit are located in a same column, where the plurality of plate line gating units and the second gating unit are connected to a same second local plate line, fourth N-channel transistors and fourth P-channel transistors of the second gating units are distributed on two sides of the plurality of plate line gating units, the fourth N-channel transistor is disposed adjacent to the third N-channel transistor, and the fourth P-channel transistor is disposed adjacent to the third P-channel transistor.

In some possible implementations, the first capacitor is a ferroelectric capacitor.

In some possible implementations, in the same column, two adjacent transistors that are of a same type share a same source or drain.

In some possible implementations, in the two adjacent memory cells in the same column, two first N-channel transistors that are adjacently disposed share a same source or drain.

In some possible implementations, in the two adjacent memory cells in the same column, two first P-channel transistors that are adjacently disposed share a same source or drain.

An embodiment of this application further provides a memory apparatus. The memory apparatus includes a controller and the memory array provided in any one of the foregoing possible implementations. The memory array is electrically connected to the controller.

An embodiment of this application further provides an electronic device. The electronic device includes a circuit board and the foregoing memory apparatus, and the memory apparatus is electrically connected to the circuit board.

### BRIEF DESCRIPTION OF DRAWINGS

FIG. 1 is a diagram of a memory array provided in a conventional technology;
FIG. 2 is a diagram of distribution of two adjacent transistors of different types in a memory array in a conventional technology;
FIG. 3 is a diagram of distribution of two adjacent transistors of a same type according to this application;
FIG. 4 is a diagram of a memory array according to an embodiment of this application;
FIG. 5 is a diagram of a structure of some memory cells in FIG. 4;
FIG. 6 is a diagram of a memory array according to an embodiment of this application;
FIG. 7 is a diagram of a memory array according to an embodiment of this application;
FIG. 8 is a diagram of a memory array according to an embodiment of this application; and
FIG. 9 is a diagram of a memory apparatus according to an embodiment of this application.

### DESCRIPTION OF EMBODIMENTS

To make objectives, technical solutions, and advantages of this application clearer, the following clearly and completely describes technical solutions in this application with reference to the accompanying drawings in this application. It is clear that the described embodiments are some but not all of embodiments of this application. All other embodiments obtained by a person of ordinary skill in the art according to embodiments of this application without creative efforts shall fall within the protection scope of this application.

In the specification, embodiments, claims, and accompanying drawings of this application, terms such as "first" and "second" are merely used for differentiation and description, but should not be understood as an indication or implication of relative importance or an indication or implication of a sequence. The term "and/or" is used to describe an association relationship between associated objects, and indicates that three relationships may exist. For example, "A and/or B" may represent the following three cases: Only A exists, only B exists, and both A and B exist, where A and B may be singular or plural. The character "/" usually indicates an "or" relationship between the associated objects. "At least one piece (item)" means one or more, and "a plurality of" means two or more. "Installation", "connection", "interconnection", and the like should be understood in a broad sense, for example, may be an electrical connection, a mechanical connection, fastening, a detachable connection, or an integrated connection; or may be a direct connection, an indirect connection through an intermediate medium, or communication between interiors of two elements. In addition, terms "include", "have", or any other variant thereof are intended to cover a non-exclusive inclusion, for example, including a series of steps or units. A method, system, product, or device is not necessarily limited to those steps or units expressly listed, but may include another step or unit not expressly listed or inherent to such a process, method, product, or device. "On", "below", "left", "right", and the like are used only relative to the orientation of the components in the accompanying drawings. These directional terms are relative concepts, are used for relative descriptions and clarifications, and may change accordingly as positions at which the components in the accompanying drawings are placed change.

An embodiment of this application provides an electronic device. The electronic device includes a memory apparatus and a circuit board (printed circuit board, PCB, which may also be referred to as a printed circuit board). The memory apparatus is disposed on the circuit board and is electrically connected to the circuit board.

A disposing form of the electronic device is not limited in this application. For example, the electronic device may be an electronic product like a mobile phone, a tablet computer, a notebook computer, a vehicle-mounted computer, a smartwatch, a smart band, or a server.

A disposing form of the memory apparatus is not limited in this application. The memory apparatus may be any apparatus or component having a storage function. For example, in some possible implementations, the memory apparatus may be a ferroelectric random access memory (FeRAM), a CPU (central processing unit, central processing unit), or an SOC (system on chip, system on chip). The following embodiments are all described by using the FeRAM as an example.

One or more memory arrays and a controller are disposed in the memory apparatus. The controller is electrically connected to the memory arrays, so that the controller controls the memory arrays, for example, performs read/write operation control on the memory array. Certainly, another electronic component like a drive component may be further disposed in the memory apparatus based on a requirement.

A basic unit of the memory array is a memory cell, and storage density of the memory array directly depends on an area of the memory cell. When the memory cell includes a P-channel transistor and an N-channel transistor, in this application, two transistors in adjacent memory cells are set to be of a same type in an extension direction of a bit line (BL), that is, in the two adjacent memory cells, two P-channel transistors are adjacently disposed or two N-channel transistors are adjacently disposed. In this case, the two transistors of the same type also use active regions of a same type, which do not need to be changed. This can reduce a quantity of times of changing active regions in the entire memory array, to further reduce a size of a component, and improve storage density. For example, in some embodiments, a quantity of times of changing the active regions in the memory array may be reduced by half.

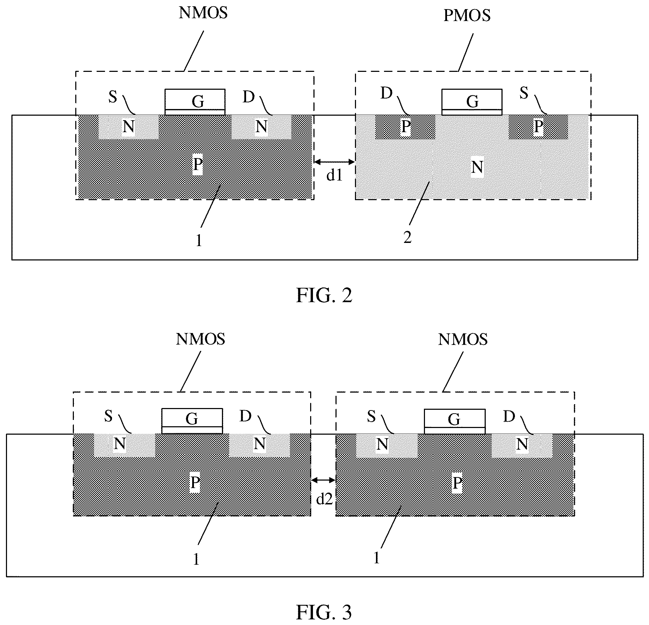

For example, FIG. 2 is a diagram of a structure of two adjacent transistors (a PMOS and an NMOS) of different types, and FIG. 3 is a diagram of a structure of two adjacent transistors (two NMOSs) of a same type.

Refer to FIG. 2. The N-channel transistor (namely, the NMOS) uses a P-channel active region 1 (namely, a P-channel doped area), and a source S and a drain D use an N-channel doped area formed in the P-channel active region 1. The P-channel transistor (namely, the PMOS) uses an N-channel active region 2 (namely, an N-channel doped area), and a source S and a drain D use a P-channel doped area formed in the N-channel active region 2. When the NMOS and the PMOS are adjacently disposed in FIG. 2, to ensure reliability of the NMOS and the PMOS, a transition area with a large width (d1) needs to be reserved between the active regions (1 and 2) of the NMOS and the PMOS, and an area of the transition area cannot be used in the memory cell. Consequently, the area of the memory cell is correspondingly increased, and improvement of the storage density is limited.

In contrast, as shown in FIG. 3, when two adjacent transistors are of a same type, and two NMOSs are disposed adjacently, the two NMOSs both use P-channel active regions, which do not need to be changed, and a transition area with a small width (d2) may be reserved between the two NMOSs. Similarly, if two PMOSs are adjacently disposed, a width of a transition area may also be reduced.

In other words, the two adjacent transistors are set to be of the same type, and the two transistors use the active regions of the same type, which do not need to be changed. This can reduce a spacing (that is, reduce transition space) between the two transistors, and reduce the area of the memory cell. This further improves the storage density.

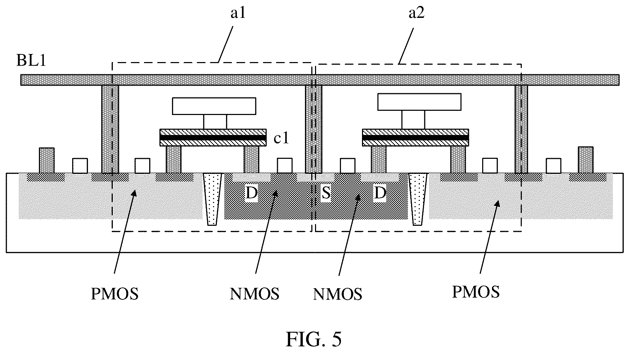

Certainly, based on an actual requirement, in some possible implementations, two adjacently disposed transistors of a same type may further use a same active region, that is, no spacing exists between the two transistors, to further reduce the area of the memory cell. This further improves the storage density. For details, refer to FIG. 5 and related descriptions below.

The following describes specific disposition of the memory array provided in embodiments of this application.

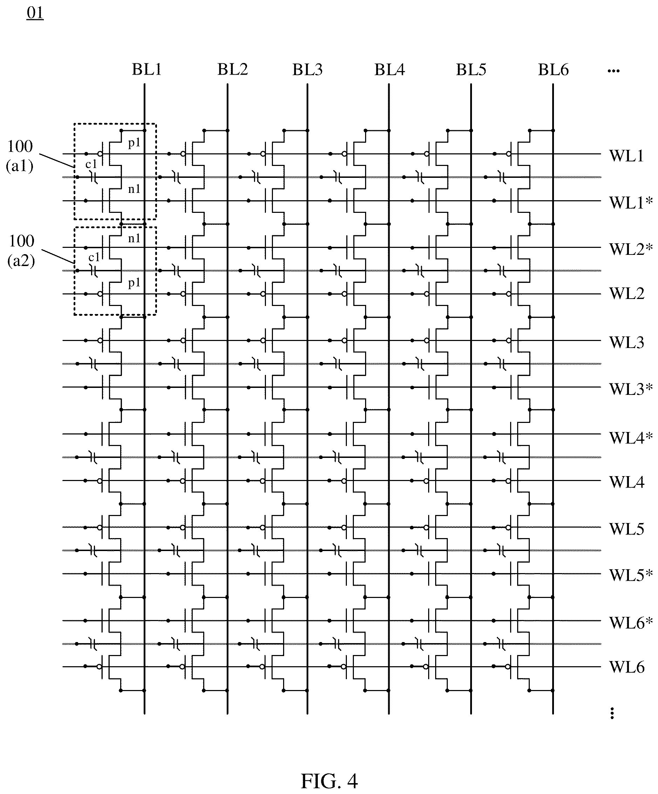

An embodiment of this application provides a memory array. Refer to FIG. 4. The memory array 01 includes a plurality of memory cells 100 arranged in an array and a plurality of bit lines (a BL1, a BL2, and the like). The plurality of bit lines (the BL1, the BL2, and the like) extend in a column direction of the memory array 01, and each memory cell 100 includes a first N-channel transistor n1 and a first P-channel transistor p1.

In a single memory cell 100, the first N-channel transistor n1 and the first P-channel transistor p1 are distributed in a same column and adjacent rows, and the first N-channel transistor n1 and the first P-channel transistor p1 are disposed in parallel, that is, a source and a drain of the first N-channel transistor n1 are electrically connected to a source and a drain of the first P-channel transistor p1 respectively. Parallel connection of two transistors in the following also means that sources and drains of the two transistors are electrically connected correspondingly. Details are not described below.

It should be noted that sources and drains of all transistors in this application are not clearly distinguished, and the sources and the drains may be specifically defined based on an actual application scenario.

In a plurality of memory cells 100 located in a same column, sources or drains of all transistors are electrically connected to a same bit line (BL). Memory cells 100 located in different columns are electrically connected to different bit lines (BL) respectively. For example, sources or drains of transistors in a plurality of memory cells 100 located in a column 1 are electrically connected to a bit line BL1, and sources or drains of transistors in a plurality of memory cells 100 located in a column 2 are electrically connected to a bit line BL2.

It should be noted herein that, in this application, "row" and "column" are a pair of relative directions. FIG. 4 is merely described by using an example in which "row" is horizontal and "column" is vertical. In some other possible implementations, "row" may alternatively be vertical, the "column" is horizontal. This is not limited in this application.

In view of this, in the memory array 01 in this application, for the plurality of memory cells 100 located in the same column, in two partially adjacent memory cells or any two adjacent memory cells (a1 and a2), two transistors of a same type are adjacently disposed. In other words, in the adjacent memory cells (a1 and a2), two first N-channel transistors n1 are adjacently disposed, or two first P-channel transistors p1 are adjacently disposed. In this way, the two transistors have active regions of a same type, which do not need to be changed. This can reduce a quantity of times of changing types of active regions in the memory arrays, and reduce a spacing between two adjacent transistors in a column direction. This can further reduce the area of the memory cell, and improve the storage density of the memory array.

For example, type-based arrangement of transistors in the memory cells 100 in a same column may be PNNPPN or NPPNNP.

Refer to FIG. 4. In the column direction, in any two adjacent (or two partially adjacent) memory cells (a1 and a2), two first N-channel transistors n1 (NMOSs) are adjacently disposed, and sources S (or drains D) of the two adjacent transistors (NMOSs) are both connected to the bit line BL1. In this case, as shown in FIG. 5, two adjacently disposed first N-channel transistors n1 may share a source structure (or share a drain structure) to form a two-finger (two-finger) structure, and the two first N-channel transistors n1 share one source S (or drain D). In this way, one of the sources S (or the drains D) is not disposed, that is, the two first N-channel transistors n1 use one active region, and no spacing exists between the two first N-channel transistors n1. This can further reduce the area of the memory cell, and improve the storage density.

Similarly, when two first P-channel transistors p1 (PMOSs) are adjacently disposed, the two first P-channel transistors p1 (PMOSs) may share a source structure (or share a drain structure), and use one active region. In this way, one of the sources S (or the drains D) is not disposed, to reduce the area of the memory cell, and improve the storage density.

In addition, as shown in FIG. 4, the memory array 01 may further include a word line group (WLn and WLn*) respectively disposed for each row of memory cells 100, and each word line group includes a first word line (WLn) and a second word line (WLn*), where n corresponds to a number of a row in which the memory cell 100 in the memory array 01 is located. Transistors in the memory cells 100 in a same row are distributed in two adjacent rows, and transistors in different rows are electrically connected to different word lines in a corresponding word line group (WLn and WLn*). For example, two rows of transistors in memory cells 100 in a row 1 are electrically connected to a first word line WL1 and a second word line WL1* in a 1^{st} word line group (WL1 and WL1*) respectively.

Certainly, in some possible implementations, in two rows of transistors in memory cells in a same row, transistors of a same type may be located in a same row and connected to a same word line. For example, in the memory cells 100 in the row 1, all first P-channel transistors p1 are located in a same row and are electrically connected to the first word line WL1, and all first N-channel transistors n1 are located in a same row and are electrically connected to the second word line WL1*. Therefore, it is ensured that transistors that are in a same row and of a same type can be controlled based on one word line, to avoid an increase in the area of the memory cell.

In addition, a first capacitor c1 is disposed in the memory cell 100. For example, the first capacitor c1 may be a ferroelectric capacitor.

For example, as shown in FIG. 4, in a single memory cell 100, the first P-channel transistor p1 and the first N-channel transistor n1 are connected in parallel between the corresponding bit line (BL) and the first capacitor c1. A memory cell 100 in the row 1 and the column 1 is used as an example. A first P-channel transistor p1 and a first N-channel transistor n1 are connected in parallel between the bit line BL1 and a first electrode of the first capacitor c1. Specifically, a gate of the first P-channel transistor p1 is electrically connected to the first word line WL1, a drain (or a source) of the first P-channel transistor p1 is connected to the bit line BL1, and the source (or the drain) of the first P-channel transistor p1 is electrically connected to the first electrode of the first capacitor c1. A gate of the first N-channel transistor n1 is electrically connected to the second word line WL1*, a drain (or a source) of the first N-channel transistor n1 is electrically connected to the first electrode of the first capacitor c1, and the source (or the drain) of the first N-channel transistor n1 is electrically connected to the bit line BL1.

A plate line (plate line, PL) electrically connected to a second electrode of the first capacitor c1 is further disposed in the memory array 01, so that the first capacitor c1 is directly or indirectly accessed via the bit line (BL) and the plate line (PL). A manner of disposing the plate line (PL) in the memory array 01, a manner of connecting the second electrode of the first capacitor c1 to the plate line (PL), and the like are not limited in this application.

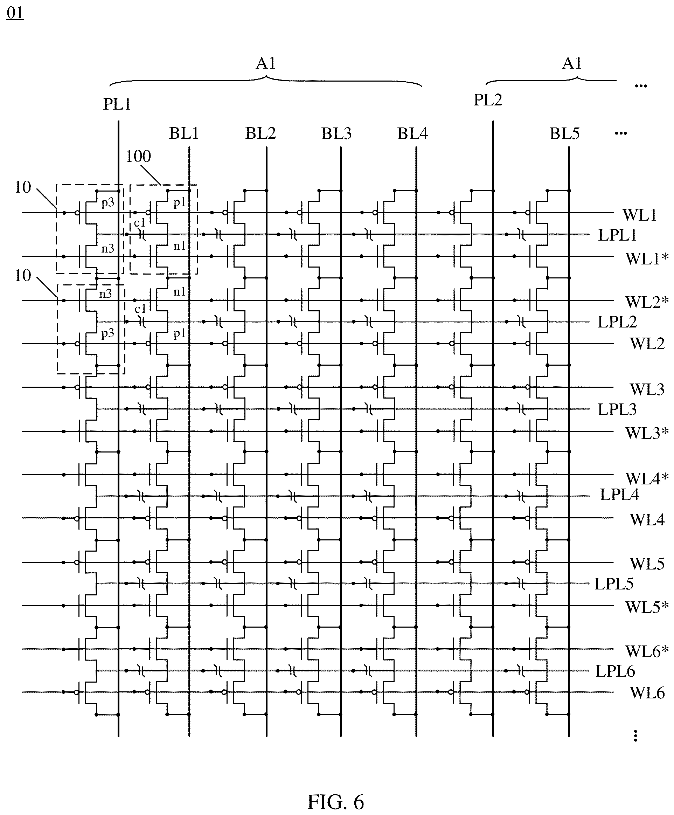

For example, as shown in FIG. 6, in some possible implementations, the memory array 01 may be divided into a plurality of memory blocks A1 in a row direction. For example, 4 columns of memory cells that are sequentially disposed in the memory array 01 may be grouped into one memory block. This is not limited thereto. Alternatively, 8 columns or 10 columns of memory cells that are sequentially disposed may be grouped into one memory block. A first plate line (PL1), a plurality of plate line gating units 10, and a plurality of first local plate lines (an LPL1, an LPL2, an LPL3, and the like) are separately disposed for each memory block A1. In each memory block A1, the plurality of first local plate lines (the LPL1, the LPL2, the LPL3, and the like) are electrically connected to second electrodes of first capacitors c1 in memory cells 100 located in different rows, and the plurality of first local plate lines (the LPL1, the LPL2, the LPL3, and the like) are separately connected to the first plate line (PL1) in the memory block A1 via the plurality of different plate line gating units 10.

A manner of disposing the plate line gating units 10 is not limited in this application, provided that it is ensured that the plurality of first local plate lines (the LPL1, the LPL2, the LPL3, and the like) can be selectively connected to/disconnected from the first plate line (PL1).

For example, as shown in FIG. 6, in some possible implementations, the plate line gating unit 10 may include a third N-channel transistor n3 and a third P-channel transistor p3 that are distributed in the column direction. The third N-channel transistor n3 and the third P-channel transistor p3 are disposed in parallel between the first local plate line (LPL1) and the first plate line (PL1).

Type-based distribution of transistors in the first plate line gating units 10 is similar to type-based distribution of the transistors in the memory cells 100. For example, transistors of a same type in adjacent first plate line gating units 10 may be disposed adjacently in the column direction, that is, in the two adjacent plate line gating units 10, two third N-channel transistors n3 are adjacently disposed, or two third P-channel transistors p3 are adjacently disposed.

In addition, two transistors in the plate line gating unit 10 and two transistors in the corresponding memory cell 100 may be further disposed in a same row, and transistors of a same type are located in a same row, so that corresponding word lines (WLn and WLn*) can be shared.

For example, as shown in FIG. 6, in the plate line gating unit 10 connected to the first local plate line LPL1, the third P-channel transistor p3 and the first P-channel transistors p1 in the plurality of memory cells 100 in the row 1 are located in a same row, and share the first word line WL1; and the third N-channel transistor n3 and the first N-channel transistors n1 in the plurality of memory cells 100 in the row 1 are located in a same row, and share the second word line WL1*.

In addition, in the memory array 01 in this application, two transistors are disposed in a single memory cell 100, and the transistors in the memory cells 100 in the same column are all connected to the same bit line (BL). Consequently, a large quantity of transistors are mounted (or loaded) on the bit line (BL), causing excessively high capacitance of the bit line BL (namely, bit line capacitance CBL), and a serious challenge brought to read signal strength, especially for the ferroelectric memory (FeRAM). Read signal strength of the ferroelectric memory depends on a ratio of a quantity Q of charges released by the ferroelectric capacitor (c1) to the bit line capacitance CBL. An output voltage V of the ferroelectric memory is equal to a ratio of ferroelectric capacitance Q to the bit line capacitance CBL. A surge of the bit line capacitance CBL weakens an output signal, causing poor reliability of the component.

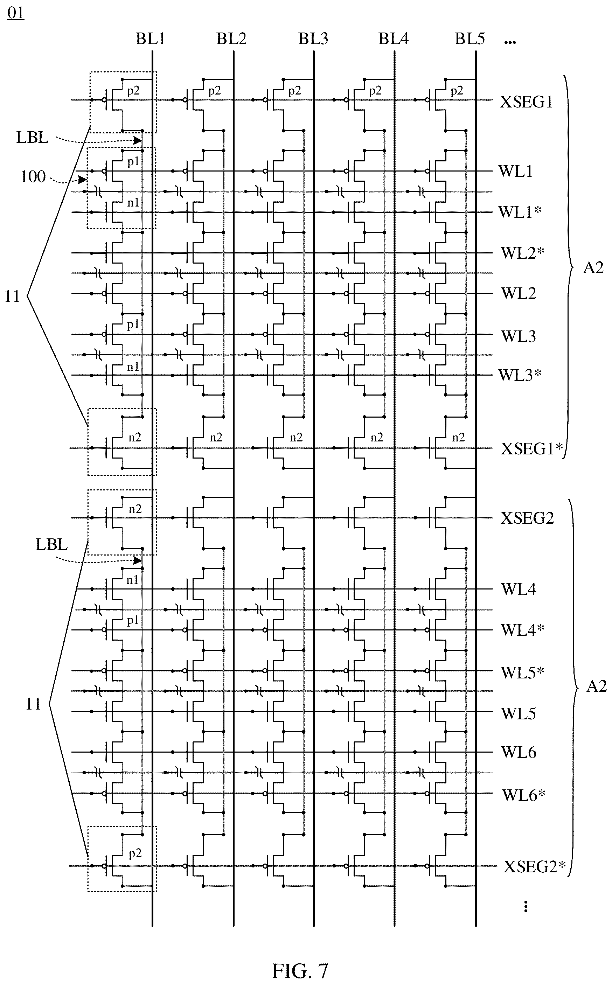

To resolve the foregoing technical problems, in some possible implementations, as shown in FIG. 7, the memory array 01 is divided into a plurality of memory blocks A2 in the column direction, that is, memory cells in a same column are divided into a plurality of parts (a quantity of memory cells in each part is not limited). A local bit line LBL (local bit line) and a first gating unit 11 are separately disposed for memory cells in each part obtained through division, and a plurality of local bit lines LBL corresponding to the memory cells 100 in the same column are separately connected to a corresponding bit line (BL) via a plurality of different first gating units 11.

For example, the memory cells 100 in the column 1 in the memory array 01 is used as an example. The memory cells 100 in the column 1 are divided into a plurality of parts, and a local bit line LBL and a first gating unit 11 are separately disposed for each of the plurality of parts obtained through division. Transistors in the plurality of parts obtained through division are connected to corresponding local bit lines LBL, and the plurality of local bit lines LBL are separately connected to the bit line BL1 via different first gating units 11.

The transistors in the memory cells in the same column are connected to the bit line BL via the plurality of local bit lines LBL in parts, so that a quantity of transistors (memory cells) that are not selected and that are directly mounted to the bit line (BL) when the memory apparatus works can be reduced. This can reduce the capacitance of the bit line (BL), to further improve a read sense margin (sense margin) of the memory apparatus.

The quantity of memory cells in the memory block A2 that are obtained through division may be determined based on an actual requirement. This is not limited in this application. For example, 10 rows of memory cells that are sequentially disposed in the memory array 01 may be grouped into one memory block A2; or 20 rows of memory cells that are sequentially disposed may be grouped into one memory block A2.

A manner of disposing the first gating units 11 is not limited in this application, provided that it is ensured that the local bit lines LBL can be selectively connected to/disconnected from the bit line (BL).

For example, as shown in FIG. 7, in some possible implementations, the first gating unit 11 may include a second N-channel transistor n2 and a second P-channel transistor p2 that are distributed in the column direction. The first gating unit 11 is connected in parallel between the local bit line LBL and the bit line BL via the second N-channel transistor n2 and the second P-channel transistor p2.

In view of this, as shown in FIG. 7, to simplify a layout design of the transistors in the first gating unit 11, transistors that are of a plurality of memory cells 100 and the first gating unit 11 that are connected to a same local bit line LBL may be disposed in a same column. The two transistors (n2 and p2) in the first gating unit 11 may be disposed on a same side (namely, a same side in the column direction) of the local bit line LBL, or may be disposed on different sides (namely, different sides in the column direction) of the local bit line LBL. This is not limited in this application.

It should be understood that, in some embodiments, because the bit line (BL) is located in high-layer metal, when the two transistors (n2 and p2) in the first gating unit 11 are disposed on the same side of the local bit line LBL, the local bit line LBL needs to bypass a via (via) that connects the bit line BL and the transistors (n2 and p2). Consequently, an area of the memory cell is increased. Therefore, to reduce the area of the memory cell, as shown in FIG. 7, the two transistors (n2 and p2) in the first gating unit 11 may be disposed on different sides (namely, different sides in the column direction) of the local bit line LBL, which is used as an example to describe the following embodiments.

To reduce a quantity of times of changing types of active regions in the memory array, type-based distribution of the transistors in the first gating unit 11 may be similar to type-based distribution of the transistors in the memory cell 100. For example, the transistor in the first gating unit 11 and a transistor adjacent to the transistor in the first gating unit 11 may be disposed in the column direction.

For example, in some possible implementations, the transistor in the first gating unit 11 may be of a same type as a transistor in an adjacent memory cell 100.

For another example, in some possible implementations, the transistor in the first gating unit 11 may be of a same type as a transistor in another adjacent first gating unit 11.

For another example, as shown in FIG. 7, the transistor in the first gating unit 11 may be of a same type as a transistor in an adjacent memory cell 100, and may also be of a same type as a transistor in another adjacent first gating unit 11, that is, types of the three consecutively disposed transistors are the same. Therefore, source (or drain) combination is performed to a greater extent, to further reduce the area of the memory cell.

For example, in some possible implementations, as shown in FIG. 7, the two transistors (n2 and p2) in the first gating unit 11 are distributed on two sides (two ends) of the local bit line LBL, the second P-channel transistor p2 is adjacent to a first P-channel transistor p1 in an adjacent memory cell 100, and the second N-channel transistor n2 is adjacent to a first N-channel transistor n1 in an adjacent memory cell 100.

In addition, as shown in FIG. 7, in a same memory block A2, a plurality of transistors located above a plurality of local bit lines LBL that are disposed in parallel are all second P-channel transistors p2, and are distributed in a same row; and a plurality of transistors located below the plurality of local bit lines LBL that are disposed in parallel are all second N-channel transistors n2, and are distributed in a same row. Gates of the plurality of second P-channel transistors p2 located in the same row are electrically connected to a first control line (XSEG1), and gates of the plurality of second N-channel transistors n2 located in the same row are electrically connected to a second control line (XSEG1*).

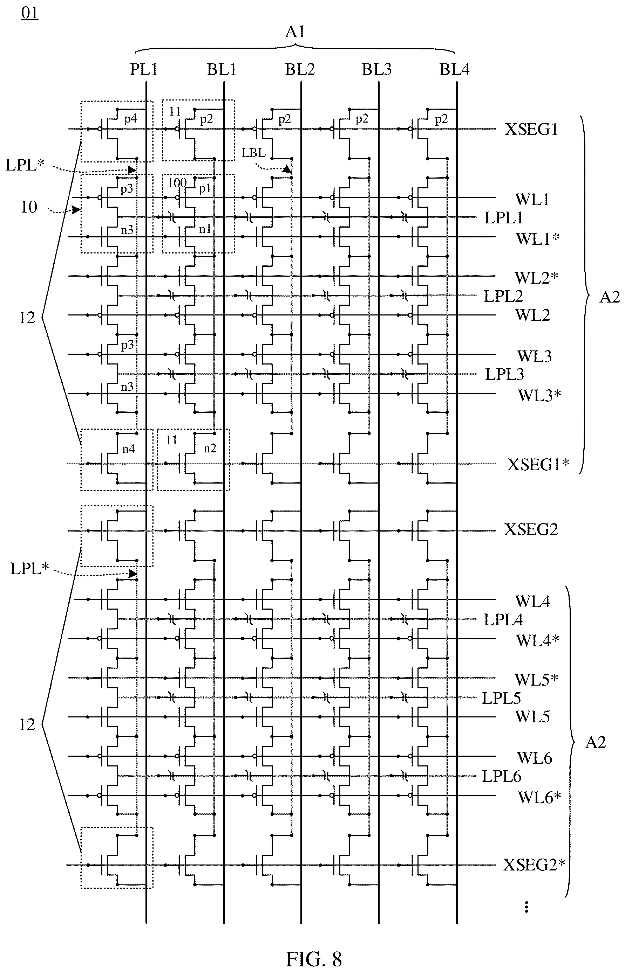

Similarly, as shown in FIG. 8, to reduce excessively high capacitance of the first plate line (PL1) and improve a signal transmission speed, in some possible implementations, a plurality of plate line gating units 10 connected to the first plate line (PL1) may be grouped, which is similar to disposition of the memory cells 100 in parts. In this case, a second local plate line LPL* and a second gating unit 12 may be separately disposed for a plurality of plate line gating units 10 in each part obtained through division in a same column, a plurality of second local plate lines LPL* in a same column are connected to a corresponding first plate line (PL1) via a plurality of different second gating units 12, and the plurality of first local plate lines (the LPL1, the LPL2, the LPL3, and the like) are separately connected to the second local plate line LPL* via the plurality of different plate line gating units 10.

A manner of disposing the second gating units 12 is not limited in this application, provided that it is ensured that the second local plate lines LPL* can be selectively connected to/disconnected from the first plate line (PL1).

For example, as shown in FIG. 8, in some possible implementations, the second gating unit 12 may include a fourth P-channel transistor p4 and a fourth N-channel transistor n4 that are distributed in the column direction. The second gating unit 12 is connected in parallel between the second local plate line LPL* and the first plate line (PL1) via the fourth P-channel transistor p4 and the fourth N-channel transistor n4.

Distribution of the fourth P-channel transistor p4 and the fourth N-channel transistor n4 in the second gating unit 12 may be similar to distribution of the second P-channel transistor p2 and the second N-channel transistor n2 in the first gating unit 11. For details, refer to the foregoing descriptions of distribution of the second P-channel transistor p2 and the second N-channel transistor n2 in the first gating unit 11.

For example, as shown in FIG. 8, in some possible implementations, the fourth P-channel transistor p4 and the fourth N-channel transistor n4 in the second gating unit 12 may be disposed on different sides (namely, different sides in the column direction) of the second local plate line LPL*, and a type of a transistor in the second gating unit 12 may be set to be the same as a type of a transistor (for example, a transistor in the first plate line gating unit 10) adjacent to the transistor in the second gating unit 12, that is, the fourth P-channel transistor p4 is adjacent to the third P-channel transistor p3, and the fourth N-channel transistor n4 is adjacent to the third N-type transistor n3.

The memory array shown in FIG. 8 is used as an example to briefly describe an actual operation of the memory array.

For example, four memory cells 100 in the row 1 are selected memory cells. A low level is input to the first control line XSEG1, a high level is input to the second control line XSEG1, and the transistors (p2 and n2) in the first gating unit 11 and the transistors (p4 and n4) in the second gating unit 12 are conducted. A low level is input to the first word line WL1, a high level is input to the second word line WL1*, and transistors (p1 and n1) in the four memory cells 100 located in the row 1 and the transistors (p3 and n3) in the plate line gating unit 10 are conducted. In this case, the first plate line PL1 is connected to the first local plate line LPL1 via the second local plate line LPL*, and a plurality of bit lines (the BL1, the BL2, a BL3, and a BL4) are connected to corresponding local bit lines LBL, so that signals on the first plate line PL1 and the plurality of bit lines (the BL1, the BL2, the BL3, and the BL4) are input to ferroelectric capacitors (c1) in the four selected memory cells 100 in the row 1. In this case, because a memory cell in another row is not selected, a ferroelectric capacitor in the memory cell is not interfered with by the signals on the first plate line PL1 and the plurality of bit lines (the BL1, the BL2, the BL3, and the BL4).

It should be noted that, in addition to the foregoing two first N-channel transistors n1 (or the two first P-channel transistors p1) that are adjacently disposed may share a source structure (or a drain structure), other two transistors of a same type in the column direction may also share a source structure (or a drain structure) when sources S (or drains D) use a same connection manner, so that one of the sources S (or the drains D) is not disposed. For example, in two adjacent plate line gating units 10, when two third N-channel transistors n3 or two third P-channel transistors p3 of a same type are adjacently disposed, one source S (or drain D) may not be disposed.

In the foregoing embodiments, an example in which the memory cell 100 is of a 2T1C structure is used for description. However, this application is not limited thereto. For example, the memory cell is also applicable to a 4T2C structure. In this case, the memory cell includes a plurality of columns of transistors, and each column of transistors is disposed in the manner same as the transistors in the memory cell of the 2T1C structure. In other words, the memory cell of the 4T2C structure is equivalent to two memory cells of the 2T1C structure that are adjacent in the row direction, and distribution of the entire memory array may remain unchanged. For details, refer to the foregoing descriptions. Details are not described herein again.

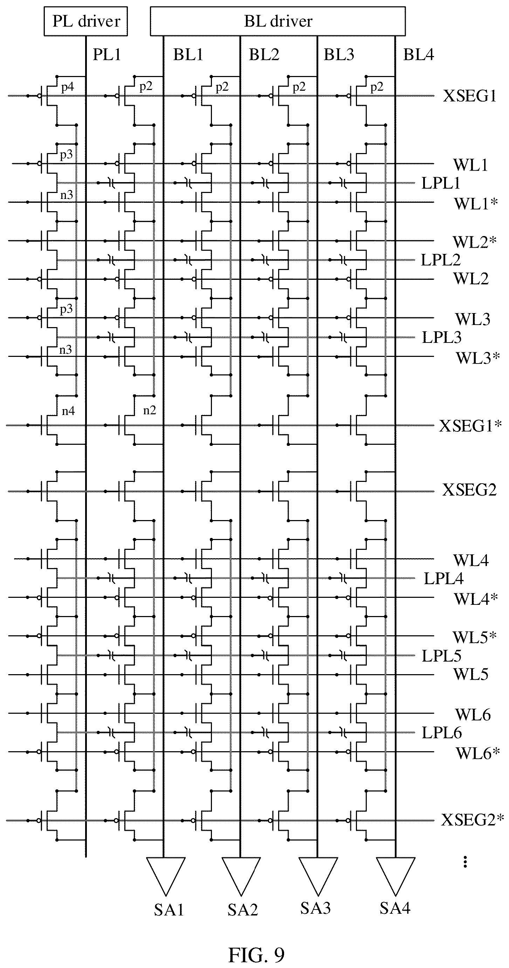

A main difference between a memory apparatus of the 2T1C structure and a memory apparatus of the 4T2C structure lies in that a connection manner between a bit line (BL) and a sense amplifier (sense amplifier, SA) is different. As shown in FIG. 9, in the memory apparatus of the 2T1C structure, different bit lines (a BL1, a BL2, a BL3, and a BL4) are respectively connected to different sense amplifiers (an SA1, an SA2, an SA3, and an SA4). In the memory apparatus of the 4T2C structure, two adjacent bit lines are connected to a same sense amplifier. For example, a bit line BL1 and a bit line BL2 are connected to a sense amplifier SA1, and a bit line BL3 and a bit line BL4 are connected to a sense amplifier SA2.

In addition, as shown in FIG. 9, another component like a plate line driver (PL driver) or a bit line driver (BL driver) may be further disposed in the memory apparatus. For example, the plate line driver (PL driver) may be separately disposed for the first plate line (PL1), and the plurality of bit lines (the BL1, the BL2, the BL3, and the BL4) may be driven by one bit line driver (BL driver).

It should be noted that the memory block A1 and the memory block A2 obtained through division in this application are manually defined areas for facilitating clearer description of the memory array, and should not be considered as a limitation on the memory array.

The foregoing descriptions are merely specific implementations of this application, but the protection scope of this application is not limited thereto. Any variation or replacement that can be readily figured out by a person skilled in the art within the technical scope disclosed in this application shall fall within the protection scope of this application. Therefore, the protection scope of this application shall be subject to the protection scope of the claims.

## Claims

1. A memory array, comprising a plurality of memory cells and a plurality of bit lines that are arranged in an array, wherein
each memory cell comprises a first N-channel transistor and a first P-channel transistor that are distributed in a column direction;
in each memory cell in a same column, a source or a drain of the first N-channel transistor and a source or a drain of the first P-channel transistor are electrically connected to a same bit line; and
in at least two partially adjacent memory cells in the same column, two first N-channel transistors are adjacently disposed or two first P-channel transistors are adjacently disposed.

2. The memory array according to claim 1, wherein
the memory array further comprises a plurality of word line groups that are respectively disposed corresponding to a plurality of rows of memory cells, and each word line group comprises a first word line and a second word line; and
in a plurality of memory cells in a same row, a plurality of first N-channel transistors are located in a same row and are electrically connected to the first word line, and a plurality of first P-channel transistors are located in a same row and are electrically connected to the second word line.

3. The memory array according to claim 1 or 2, wherein
the memory array further comprises a plurality of local bit lines and a plurality of first gating units that are disposed corresponding to each bit line; and
transistors of a plurality of memory cells in the same column are connected in parts to the plurality of local bit lines, and the plurality of local bit lines are connected to the bit line by using the plurality of first gating units respectively.

4. The memory array according to claim 3, wherein
the first gating unit comprises a second N-channel transistor and a second P-channel transistor that are distributed in the column direction, and the local bit line is connected to the bit line by using the second N-channel transistor and the second P-channel transistor that are connected in parallel; and
transistors of a plurality of memory cells and transistors of a first gating unit are located in a same column, wherein the plurality of memory cells and the first gating unit are connected to a same local bit line, second N-channel transistors and second P-channel transistors of the first gating units are distributed on two sides of the plurality of memory cells, the second N-channel transistor is disposed adjacent to the first N-channel transistor, and the second P-channel transistor is disposed adjacent to the first P-channel transistor.

5. The memory array according to any one of claims 1 to 4, wherein
the memory cell further comprises a first capacitor electrically connected to the first N-channel transistor and the first P-channel transistor;
the memory array further comprises a first plate line, a plurality of plate line gating units, and a plurality of first local plate lines that are disposed corresponding to a plurality of columns of memory cells, and the plurality of first local plate lines are electrically connected to first capacitors in the plurality of memory cells located in different rows respectively;
the first plate line is electrically connected to the plurality of first local plate lines by using the plurality of plate line gating units respectively;
the plate line gating unit comprises a third N-channel transistor and a third P-channel transistor that are distributed in the column direction, and the first plate line is connected to the first local plate line by using the third N-channel transistor and the third P-channel transistor that are connected in parallel; and
the plurality of plate line gating units are distributed in the column direction, and in at least two partially adjacent plate line gating units, two third N-channel transistors are adjacently disposed or two third P-channel transistors are adjacently disposed.

6. The memory array according to claim 5, wherein
the memory array further comprises a plurality of second local plate lines and a plurality of second gating units that are disposed corresponding to the first plate line; and
transistors of the plurality of plate line gating units are connected in parts to the plurality of second local plate lines, and the plurality of second local plate lines are connected to the first plate line by using the plurality of second gating units respectively.

7. The memory array according to claim 6, wherein
the second gating unit comprises a fourth N-channel transistor and a fourth P-channel transistor that are distributed in the column direction;
the second local plate line is connected to the first plate line by using the fourth N-channel transistor and the fourth P-channel transistor that are connected in parallel; and
transistors of a plurality of plate line gating units and transistors of a second gating unit are located in a same column, wherein the plurality of plate line gating units and the second gating unit are connected to a same second local plate line, fourth N-channel transistors and fourth P-channel transistors of the second gating units are distributed on two sides of the plurality of plate line gating units, the fourth N-channel transistor is disposed adjacent to the third N-channel transistor, and the fourth P-channel transistor is disposed adjacent to the third P-channel transistor.

8. The memory array according to any one of claims 5 to 7, wherein
the first capacitor is a ferroelectric capacitor.

9. The memory array according to any one of claims 1 to 8, wherein
in the two adjacent memory cells in the same column, two first N-channel transistors that are adjacently disposed share a same source or drain.

10. The memory array according to any one of claims 1 to 9, wherein
in the two adjacent memory cells in the same column, two first P-channel transistors that are adjacently disposed share a same source or drain.

11. The memory array according to any one of claims 1 to 9, wherein
in a plurality of transistors located in the same column, at least two transistors that are partially adjacent and that are of a same type share a same source or drain.

12. A memory apparatus, comprising a controller and the memory array according to any one of claims 1 to **11,** wherein the memory array is electrically connected to the controller.

13. An electronic device, comprising a circuit board and the memory apparatus according to claim 12, wherein the memory apparatus is electrically connected to the circuit board.
